Europäisches Patentamt

European Patent Office

Office européen des brevets

(11) Veröffentlichungsnummer: **0 298 410**
**A1**

(12) **EUROPÄISCHE PATENTANMELDUNG**

(21) Anmeldenummer: 88110669.4

(22) Anmeldetag: 04.07.88

(51) Int. Cl.4: **H01R 4/02 , H05K 3/34**

(30) Priorität: 06.07.87 DE 8709301 U

(43) Veröffentlichungstag der Anmeldung:
**11.01.89 Patentblatt 89/02**

(84) Benannte Vertragsstaaten:
**CH DE FR GB LI**

(71) Anmelder: **Siemens Aktiengesellschaft Berlin und München**
**Wittelsbacherplatz 2**
**D-8000 München 2(DE)**

(72) Erfinder: **Roslavlev, Swet, Dipl.-Ing.**
**Heinleinstrasse 14**
**D-8000 München 71(DE)**
Erfinder: **Aigner, Georg, Ing.(grad.)**
**Solothurner Strasse 40**
**D-8000 München 71(DE)**

(54) **Elektrisches Bauteil mit Anschlussstiften.**

(57) Elektrisches Bauteil, insbesondere Relais, mit Anschlußstiften (4) zum Einlöten des Bauteiles in Leiterplatten (1), wobei die Anschlußstifte (4) aus flachem Material, z.B. Blech, bestehen. Auf der Oberfläche der Anschlußstifte ist eine Riffelung (6) angebracht, mit der sich durch die Kapillarwirkung der Furchen der Riffelung ein verbessertes Hochsteigen des Lotes an dem Anschlußstift von der Lötstelle her erzielen läßt. Andererseits kann aber auch das Hochsteigen des Lotes begrenzt werden, indem die Riffelung (8) quer zur erwünschten Fließrichtung des Lotes gelegt wird.

FIG 1

EP 0 298 410 A1

## Elektrisches Bauteil mit Anschlußstiften

Die Erfindung betrifft ein elektrisches Bauteil mit Anschlußstiften zum Einlöten auf Leiterplatten, insbesondere Relais.

Elektrische Bauteile zum Einlöten auf Leiterplatten sind bekanntlich mit Anschlußdrähten oder Anschlußstiften aus flachem Material versehen. Auch ist das stumpfe Auflöten von Anschlußflächen auf Leiterbahnen von Leiterplatten üblich geworden. Die unterschiedliche Beschaffenheit der elektrischen Bauteile beim Verlöten mit Leiterplatten bringt Probleme mit sich, da manche Bauteile bei höheren Temperaturen und längerer Erwärmung Schaden nehmen können, während andere Bauteile gerade wiederum höhere Temperaturen oder längere Lötzeiten wegen der stark wärmeableitenden Anschlußstifte erfordern.

Es ist bekannt, durch Querschnittsverkleinerung der in das Bauteil führenden Partien der Lötstifte die Wärmeableitung zu verringern. Dies kann jedoch zu einer unerwünschten Erwärmung im Betrieb führen, da die Stromführung verschlechtert ist. Auch ist es bekannt, anstelle von Kupfer als Material für den Anschlußstift Messing zu wählen und damit die Wärmeleitfähigkeit bei ausreichender Stromleitfähigkeit herabzusetzen.

Mit der Erfindung wird die Aufgabe gelöst, im Hinblick auf das oben gechilderte Problem die Lötfähigkeit bei Anschlußstiften elektrischer Bauteile zu verbessern, um mit möglichst kurzen Lötzeiten bzw. niedrigeren Temperaturen eine zuverlässige Lötung zu erzielen.

Aus dem Deutschen Gebrauchsmuster 81 07 957 ist es bekannt, die Durchführungslöcher für die Anschlußstifte bei Bauelementege häusen oder Bodenplatten von Relais mit einem zunächst flüssigen Dichtungsmittel abzudichten, welches den Anschlußstift in der Öffnung umgibt und später fest wird. Um ein Eindringen des Dichtungsmittels in die Gehäuseöffnung am Anschlußstift zu erleichtern, ist es bekannt, die Anschlußstifte mit einer Rillenstruktur dort zu versehen, wo die Dichtungsmasse wirksam sein soll. Bei der vorliegenden Erfindung liegt demgegenüber die andersartige Aufgabe vor, die Verlötung der Anschlußstifte mit der Leiterplatte zu verbessern.

Erfindungsgemäß wird hierzu vorgeschlagen, daß die Anschlußstifte, insbesondere bei flachen Stiften, deren Breitseiten mit einer Riffelung in Fließrichtung des Lotes versehen sind, derart, daß ein Aufsteigen des Lotes am Anschlußstift bewirkt wird. Durch die Riffelung und die damit verbundene Vergrößerung der Oberfläche ergibt sich eine schnellere Erwärmung des Lötstiftes durch das herangebrachte Lot und in Verbindung mit der Kapillarwirkung der Riffelung eine raschere Benetzung der Oberfläche verbunden mit einem schnelleren Hochsteigen des Lotes im Bereich der Lötstelle.

Form und Größe der Riffelung ist dem jeweiligen Einsatzbedingungen anzupassen. Im vorliegenden Fall hat es sich als vorteilhaft erwiesen, wenn die Riffelung jeweils eine Breite von 0,30 mm für jede Furche aufweist. Die Riffelung kann ggf. auch erst bei der Fertigung des Bauteils z. B. durch Einpressen angebracht werden. Ferner kann die Riffelung auch quer zu einer unerwünschten Fließrichtung des Lotes oder auch von anderen Flüssigkeiten, wie Vergußmasse, Kleber, Wasser und dergleichen angebracht werden. Diese Mittel werden dann im flüssigen Zustand festgehalten und am Weiterfließen gehindert. Dies hat jedoch nichts mit der Aufrauhung oder Kordelung von Oberflächen zu tun, die in Kunststoff eingebettet werden und dort einen besonders sicheren formschlüssigen Sitz erhalten sollen.

Ein Ausführungsbeispiel ist nachstehend anhand der Zeichnung erläutert.

FIG 1 zeigt schematisch die Ansicht eines Anschlußstiftes für ein elektrisches Bauteil,

FIG 2 zeigt den Schnitt durch den Anschlußstift nach FIG 1 und

FIG 3a bis 3b zeigt mögliche Formen der Riffelung in vergrößerter Darstellung.

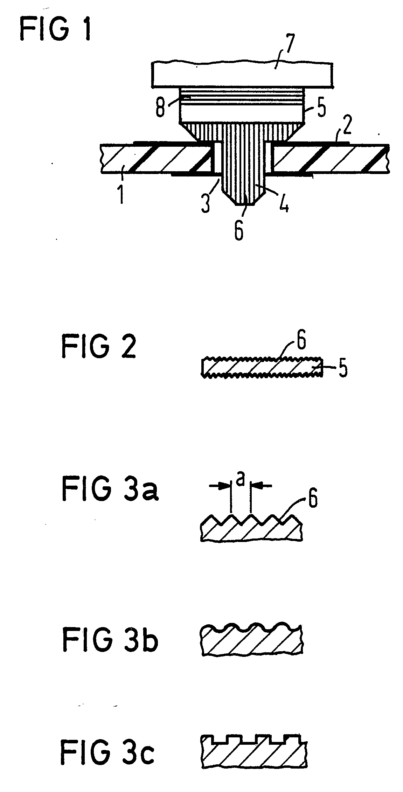

In FIG 1 ist mit 1 eine Leiterplatte aus Isolierstoff bezeichnet. Mit 2 sind die leitenden Beläge der Doppelkaschierung aus Kupfer bezeichnet, mit denen Anschlußstifte 4 des Bauteiles 7 z.B. Relais verlötet werden soll. Der Anschlußstift 4 ist in eine Bohrung 3 der Leiterplatte 1 eingeführt. Der verbreiterte obere Teil 5 des Anschlußstiftes 4 hat beispielsweise die Aufgabe, einen bestimmten Abstand des Bauteiles 7 von der Leiterplatte 1 sicherzustellen. Der Teil 5 kann jedoch auch die Aufgabe haben, die Lötverbindung mit den Kupferbelägen 2 zu verbessern, indem eine noch großflächigere Lotverbindung mit den Kupferbelägen 2 hergestellt wird. Erfindungsgemäß ist der Anschlußstift 4 mit einer Riffelung 6 versehen, die in FLießrichtung des Lotes verläuft. Dargestellt ist ferner eine Riffelung 8, die in Sperr-Richtung für das Lot wirksam ist. Das Lot wird beispielsweise von unten her als Schwall gegen die Leiterplatte 1 geführt und tritt auch oben aus der Bohrung 3 aus. Die Riffelung 6 läßt es bis zum verbreiterten Teil 5 aufsteigen. Die Riffelung 8 wirkt einem Aufsteigen des Lotes in das Gehäuse des Bauteiles 7 entgegen und verhindert auch ggf. ein Ausfließen von Dichtungsmittel.

FIG 2 zeigt einen Schnitt durch den unteren Teil 5 des Stiftes 4. Die äußere Oberfläche an den Deckseiten ist dabei mit einer Riffelung 6 versehen, die in FIG 3a nochmals vergrößert dargestellt ist. Jede einzelne Rinne der Riffelung kann im Anwendungsbeispiel zweckmäßg eine Breite a von 0,30 mm besitzen, wobei die Flächen der Furchen jeweils einen Winkel von etwa 90° einschließen. Die Riffelung 6 auf dem Anschlußstift 4 läßt sich zweckmäßig bei der Herstellung des Bauteiles 7 durch Einpressen anbringen. FIG 3b und 3c zeigen weitere Ausführungsformen.

## Ansprüche

1. Elektrisches Bauteil, insbesondere Relais (7), mit flachen Anschlußstiften (4) zum Einlöten auf Leiterplatten (1) **dadurch gekennzeichnet,** daß die Anschlußstifte (4), insbesondere bei flachen Stiften, deren Breitseiten eine Riffelung (6) in Fließrichtung des Lotes aufweisen, derart, daß ein Aufsteigen des Lotes am Anschlußstift (4) gefördert wird.

2. Elektrisches Bauteil nach Anspruch 1, **dadurch gekennzeichnet,** daß zur Begrenzung der mit Lot zu bedeckenden Oberfläche der Anschlußstift (4) senkrecht zur Fließrichtung des Lotes bzw. zur Achsrichtung der Anschlußstifte (4) verlaufende Riffelungen (8) vorgesehen sind.

3. Elektrisches Bauteil nach Anspruch 1 oder 2, **dadurch gekennzeichnet,** daß die Riffelung (6, 8) jeweils etwa 0,30 mm breit ist.

4. Elektrisches Bauteil nach einem der Ansprüche 1 bis 3 , **dadurch gekennzeichnet,** daß die Riffelung (6, 8) auf den Anschlußstiften (4) bei der Herstellung des Bauteiles (7) z.B. durch Einpressen angebracht ist.

EP 0 298 410 A1

FIG 1

7

8    5

2

1    3    4

6

FIG 2    6

5

FIG 3a    a    6

FIG 3b

FIG 3c

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | DE-A-1 665 608 (SIEMENS) * Figuren 1-3, 6; Ansprüche 1, 4, 5; Seite 2, Absatz 2 - Seite 4, Absatz 3 * | 1 | H 01 R 4/02 H 05 K 3/34 |
| A | | 4 | |
| Y | EP-A-0 043 224 (McKENZIE) * Figuren 1-3; Seite 8, Zeile 10 - Seite 10, Zeile 11 * | 1 | |
| A | | 2 | |

RECHERCHIERTE SACHGEBIETE (Int. Cl.4)

H 01 R 4/02
H 05 K 3/34

Der vorliegende Recherchenbericht wurde für alle Patentansprüche erstellt

| Recherchenort | Abschlußdatum der Recherche | Prüfer |
|---|---|---|
| BERLIN | 30-09-1988 | HAHN G |

KATEGORIE DER GENANNTEN DOKUMENTE

X : von besonderer Bedeutung allein betrachtet
Y : von besonderer Bedeutung in Verbindung mit einer
   anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
   nach dem Anmeldedatum veröffentlicht worden ist
D : in der Anmeldung angeführtes Dokument
L : aus andern Gründen angeführtes Dokument
........................................................................
& : Mitglied der gleichen Patentfamilie, übereinstimmendes
   Dokument

EPO FORM 1503 03.82 (P0403)